# EUROPEAN PATENT APPLICATION

(11) **EP 4 654 177 A1**
(43) Date of publication of application: **26.11.2025**
(21) Application number: 25176874.3
(22) Date of filing: 16.05.2025
(51) Int. Cl.: G09F 9/30, G09F 21/04

(54) **INFORMATION DISPLAY DEVICE AND DISPLAY**

(30) Priority: 23.05.2024 JP 2024084217
(71) Applicant: Panasonic Intellectual Property Management Co., Ltd., Kadoma-shi, Osaka 571-0057 (JP)
(72) Inventor: ODORIBA, Yuki, Kadoma-shi, Osaka 571-0057 (JP); MATSUMOTO, Masaharu, Kadoma-shi, Osaka 571-0057 (JP)
(74) Representative: Eisenführ Speiser

(57) **Abstract**

An information display device (10) includes: a surface member (30) that is provided to a structure (40) and includes a front surface (39) that is curved; and a display (100). The display (100) includes: a fixing part (110) that is fixed to the structure (40); and a deformable display part (120) that displays information, is deformable, and is partially fixed to the fixing part (110). The deformable display part (120) is disposed, in a shape that conforms to the surface member (30), between the surface member (30) and the structure (40) to display the information through the surface member (30).

## Description

### Field

The present disclosure relates to an information display device and a display.

### Background

An information display device that can improve the designability of a space by covering a display with a surface member and causing information to be displayed through the surface member on a wall without making a user aware of the presence of the display (for example, see PTL 1).

### Citation List

### Patent Literature

PTL 1: US Patent No. 11340488

### Summary

### Technical Problem

For example, an information display device that causes information to be displayed through a surface member is assumed to be provided in the vicinity of a seat or the like of an airplane or the like; however, the shape of a wall in the vicinity of such a seat is not limited to a flat shape, and a curved wall is preferably used.

Then, the present disclosure provides: an information display device that causes information to be displayed through a surface member and can conform to a curved shape; and a display that is included in the information display device.

### Solution to Problem

An information display device according to an aspect of the present disclosure is an information display device to be provided to a structure. The information display device includes: a surface member that is provided to the structure and includes a front surface that is curved; and a display. The display includes: a fixing part that is fixed to the structure; and a deformable display part that displays information, is deformable, and is partially fixed to the fixing part. The deformable display part is disposed between the surface member and the structure to display the information through the surface member. The deformable display part is disposed in a shape that conforms to the surface member.

A display according to an aspect of the present disclosure is the display included in the information display device.

### Advantageous Effects

According to the present disclosure, an information display device that causes information to be displayed through a surface member can conform to a curved shape.

### Brief Description of Drawings

**[****FIG. 1****]**

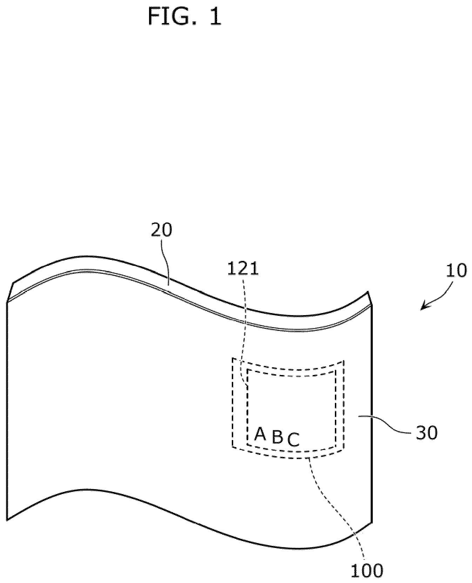

   FIG. 1 is a schematic view for describing the outline of an information display device according to an embodiment.
**[****FIG. 2****]**

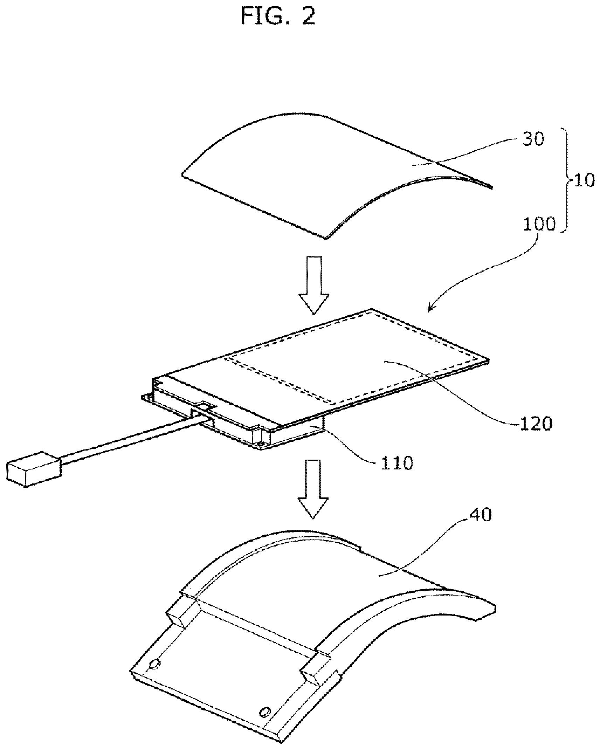

   FIG. 2 is a schematic perspective view for describing installation of the information display device according to the embodiment on a structure.
**[****FIG. 3A****]**

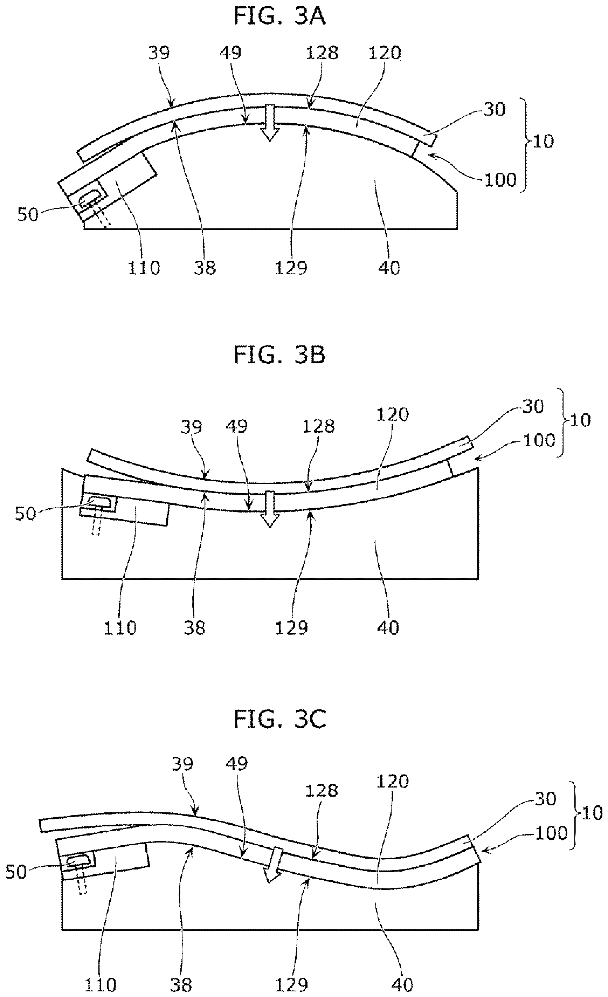

   FIG. 3A is a schematic side view illustrating an example of a state in which the information display device according to the embodiment is provided to a structure.
**[****FIG. 3B****]**
   FIG. 3B is a schematic side view illustrating another example of a state in which the information display device according to the embodiment is provided to a structure.
**[****FIG. 3C****]**
   FIG. 3C is a schematic side view illustrating yet another example of a state in which the information display device according to the embodiment is provided to a structure.
**[****FIG. 4****]**

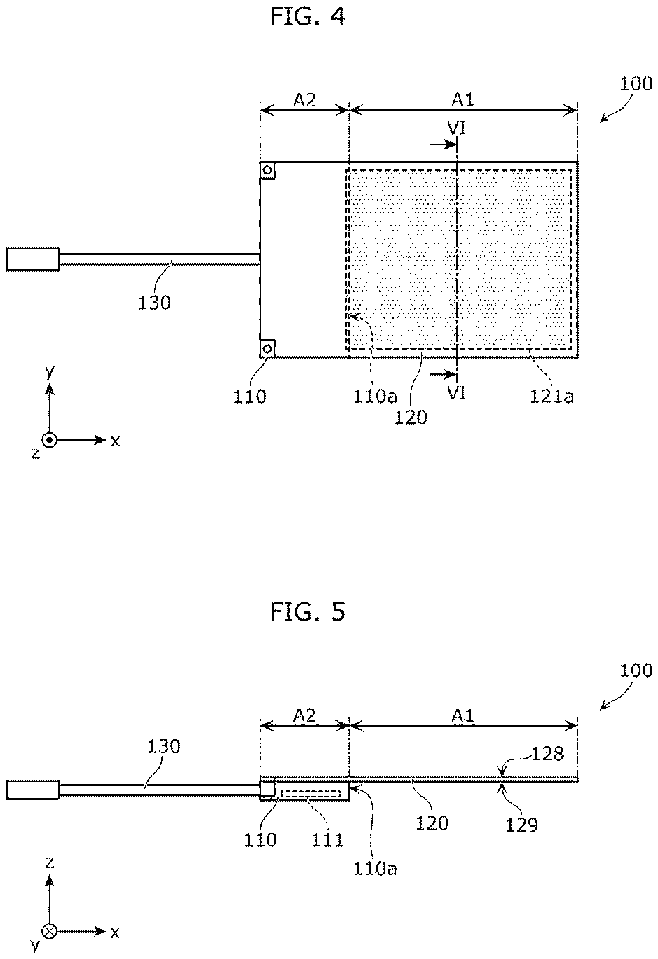

   FIG. 4 is a schematic top view of a display according to the embodiment.
**[****FIG. 5****]**
   FIG. 5 is a schematic side view of the display according to the embodiment.
**[****FIG. 6****]**

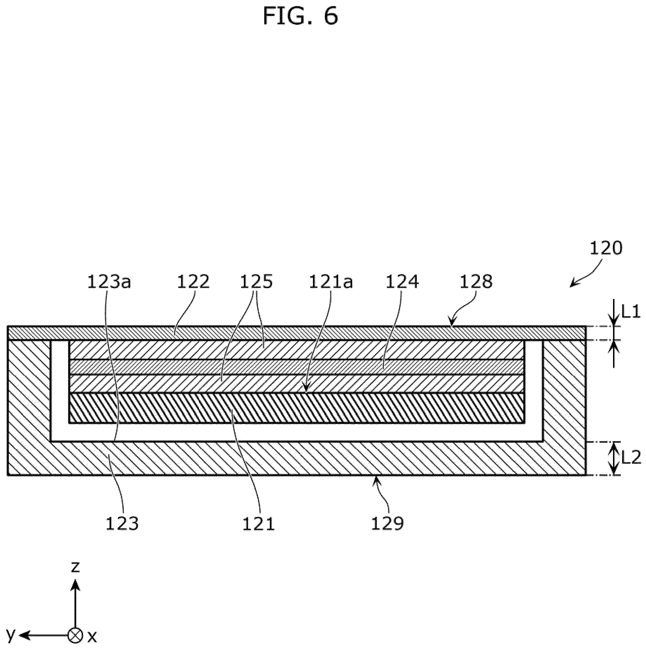

   FIG. 6 is a schematic cross-sectional view of a deformable display part of the display according to the embodiment.
**[****FIG. 7****]**

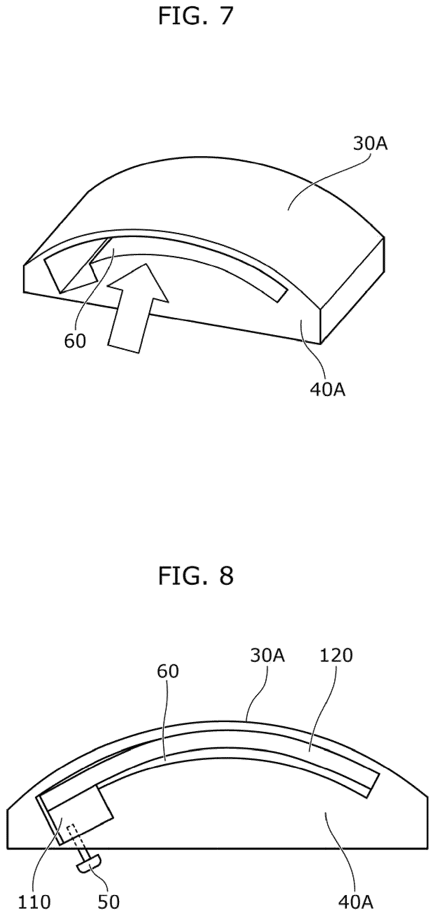

   FIG. 7 is a schematic perspective view for describing a surface member and a structure that have an other configuration according to the embodiment.
**[****FIG. 8****]**
   FIG. 8 is a schematic side view illustrating a state in which the display according to the embodiment is provided to the structure that has the other configuration.
**[****FIG. 9****]**

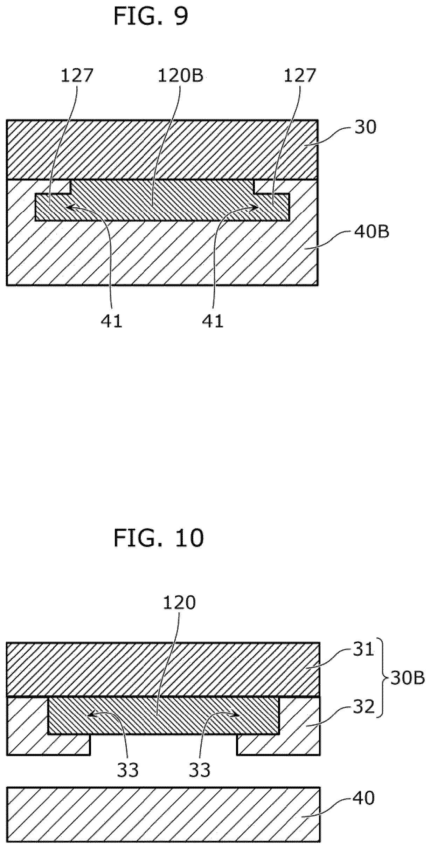

   FIG. 9 is a schematic cross-sectional view illustrating a state in which the deformable display part according to the embodiment is disposed along a guide provided to a structure.
**[****FIG. 10****]**
   FIG. 10 is a schematic cross-sectional view illustrating a state in which the deformable display part according to the embodiment is disposed along a guide provided to a surface member.
**[****FIG. 11****]**

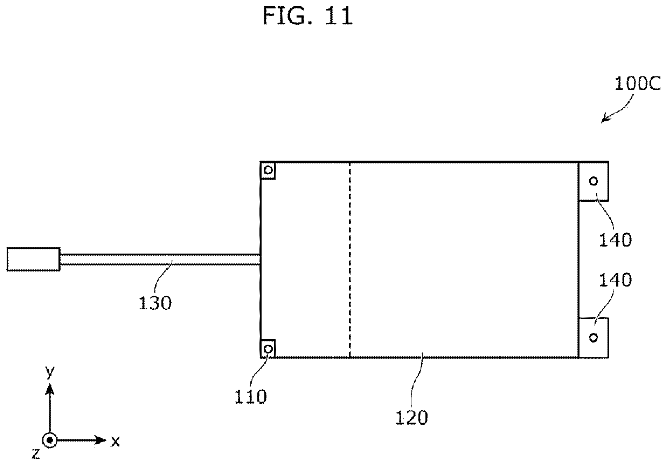

   FIG. 11 is a schematic top view illustrating a display that has an other configuration according to the embodiment.
**[****FIG. 12****]**

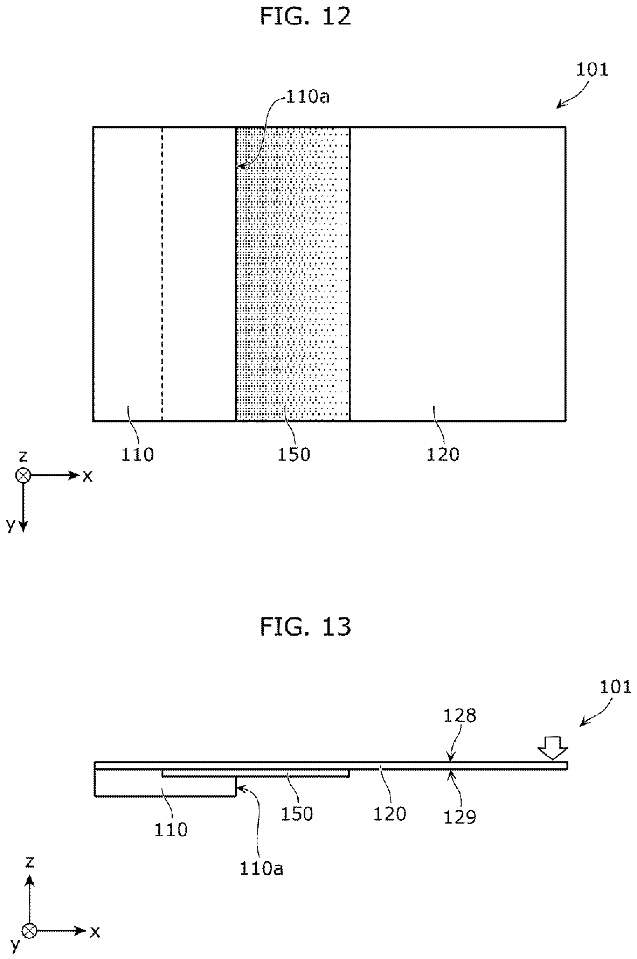

   FIG. 12 is a schematic bottom view of a display according to a variation of the embodiment.
**[****FIG. 13****]**
   FIG. 13 is a schematic side view of the display according to the variation of the embodiment.
**[****FIG. 14****]**

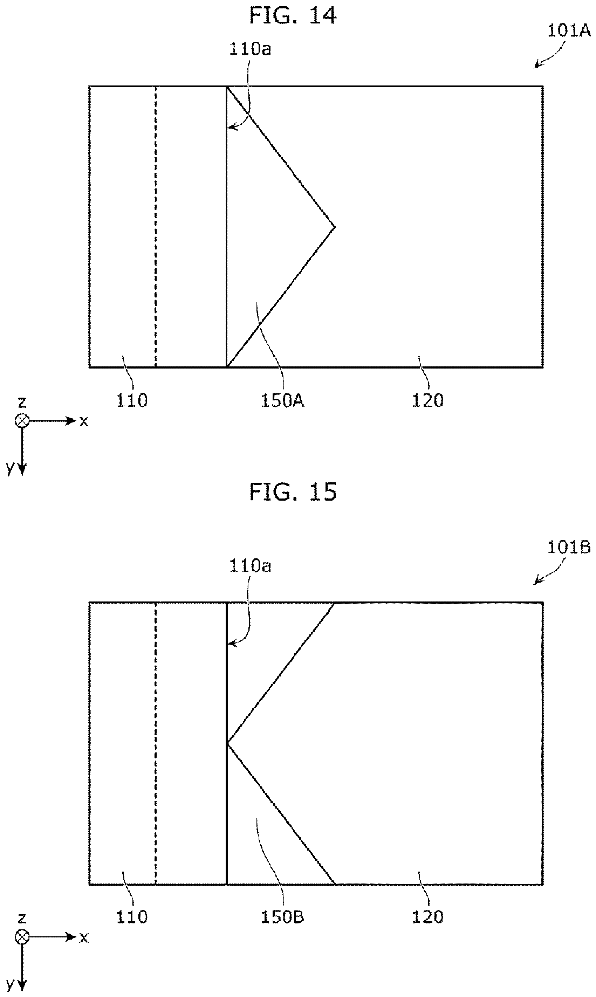

   FIG. 14 is a schematic bottom view of a display including a reinforcement part according to a first example of the variation of the embodiment.
**[****FIG. 15****]**
   FIG. 15 is a schematic bottom view of a display including a reinforcement part according to a second example of the variation of the embodiment.
**[****FIG. 16****]**

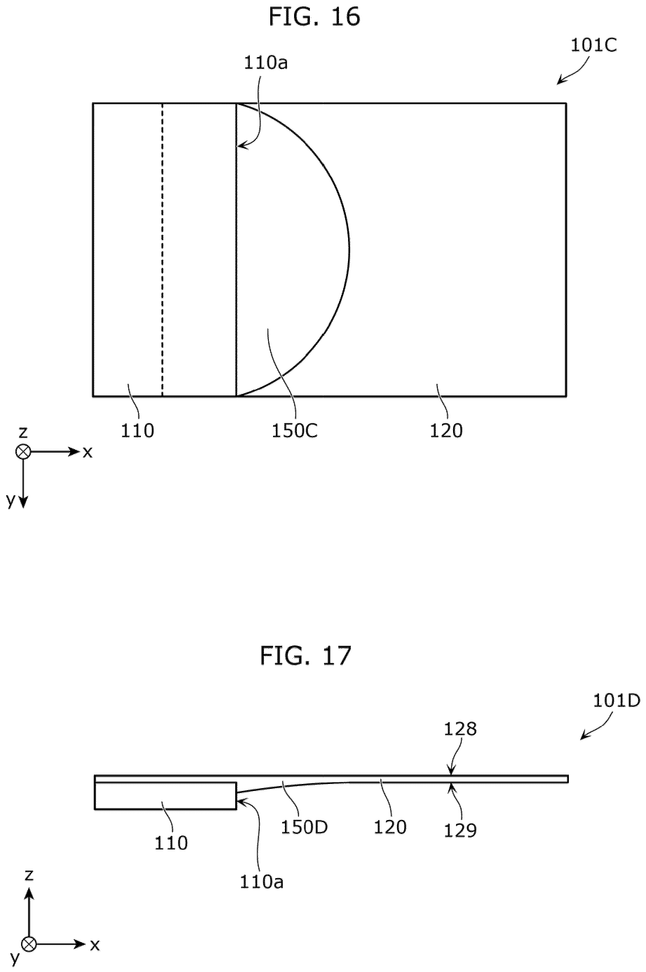

   FIG. 16 is a schematic bottom view of a display including a reinforcement part according to a third example of the variation of the embodiment.
**[****FIG. 17****]**
   FIG. 17 is a schematic side view of a display including a reinforcement part according to a fourth example of the variation of the embodiment.

### Description of Embodiment

Hereinafter, an embodiment is specifically described with reference to the Drawings.

It should be noted that the embodiment described below shows a general or specific example. The numerical values, shapes, materials, constituent elements, the arrangement and connection of the constituent elements, steps, the processing order of the steps, etc. shown in the following embodiment are mere examples, and therefore do not limit the scope of the present disclosure. Moreover, among the constituent elements in the following embodiment, constituent elements not recited in any one of the independent claims are described as arbitrary constituent elements.

Furthermore, the Drawings are schematic drawings and are not necessarily precise depictions. Furthermore, in each of the Drawings, components that are substantially the same share like reference signs, and overlapping description thereof may be omitted or simplified.

Furthermore, in the present Specification, a term, such as parallel, that indicates relation between elements; a term, such as rectangle, that indicates the shape of an element; and a numerical range are not precise expressions and include the substantially same range or a margin of error of a few percent, for example.

Furthermore, in a drawing illustrating a display, the x-axis, the y-axis, and the z-axis indicate the three axes in a three-dimensional orthogonal coordinate system. The z-axis indicates a direction parallel to a thickness direction of a display panel included in the display. Moreover, a surface on the positive side in the z-axis direction is referred to as an "upper surface", a surface on the negative side in the z-axis direction is referred to as a "lower surface", and a surface parallel to the z-axis direction is referred to as a "side surface"; however, they only indicate a relative positional relationship and do not limit the orientation in manufacture or use of the display according to the present disclosure.

In the following description, unless otherwise specified, a "front surface" of a constituent element of an information display device is a surface that is closer to a user watching the information display device and on which ambient light or external light is incident (i.e., a surface that faces the same direction as a display surface of the display panel). Moreover, a "rear surface" of a constituent element of an information display device is a surface that faces away from a "front surface" and is located on a side opposite to the "front surface".

### Embodiment

Hereinafter, a display according to an embodiment and an information display device that includes the display will be described.

### [Configuration]

FIG. 1 is a schematic view for describing the outline of an information display device according to the present embodiment. It should be noted that, in FIG. 1, the outline of display 100 provided in wall 20 and the outline of display panel 121 included in display 100 are illustrated by broken lines.

As illustrated in FIG. 1, information display device 10 according to the present embodiment is disposed in wall 20 and includes surface member 30 and display 100. Wall 20 is part of the interior of a mobile body, such as a wall for separating seats. The mobile body is, for example, an airplane and is not particularly limited as long as the mobile body can move while carrying a person. The mobile body may be a vehicle, a ship, and so on. The vehicle is, for example, an automobile, a train, or the like. A place where information display device 10 is provided is not limited to wall 20 and may be a seat, a ceiling, a floor, a shelf, a desk, or the like.

Information display device 10 provides information to a user by displaying the information on surface member 30. The user is, for example, an occupant riding on the mobile body, such as a passenger or a crew member. The information is, for example, content information, text information, an image, a video, or the like. In information display device 10, the light of display panel 121 of display 100 passes through surface member 30 from the rear side of surface member 30, and thus the information is displayed on surface member 30. Information display device 10 may display an operation screen on surface member 30. In this case, the user can operate the operation screen displayed on surface member 30 to change the information displayed or make a request to a crew member, for example.

When the power of information display device 10 is turned on, the light of display panel 121 is turned on and the information is displayed on a front surface of surface member 30. At this time, only the information displayed on display panel 121 becomes visible to the user through surface member 30. In contrast, when the power of information display device 10 is turned off, the light of display panel 121 is turned off. At this time, display 100 becomes in a state in which display 100 is almost not seen by the user through surface member 30, that is, display 100 becomes almost invisible to the user through surface member 30. Moreover, even when the power of information display device 10 is turned on and the light of display panel 121 is turned on, a portion (a background color portion) of display panel 121 in which the information is not displayed becomes in a state in which the portion is almost not seen by the user through surface member 30, that is, the portion becomes almost invisible to the user through surface member 30.

Examples of information and operation content presented to a user (e.g., a passenger or crew member) when information display device 10 is used in an airplane may include: transit information; reading light control; audio control; Do Not Disturb settings; entertainment device control; seat reclining; attendant call and cancellation of the call; weather information; information on flight time, local time, and so on; seat number; lavatory availability; seat belt sign; and door mode status. Moreover, information display device 10 may include a function of turning the light of display panel 121 on by a touch panel, motion sensor, or the like only when a user approaches information display device 10.

Surface member 30 is a member that is disposed on the front surface of wall 20, and is at least part of a member constituting the front surface of wall 20. There may be a boundary between surface member 30 and a part of the front surface of wall 20 other than surface member 30. Surface member 30 includes a front surface that is curved. Surface member 30 is bigger than display panel 121 (a display surface of display panel 121). In other words, display panel 121 is covered with surface member 30 including the front surface of which area is larger than the area of a front surface of display panel 121. Accordingly, since an edge of surface member 30 is not disposed at a position overlapping display panel 121, the user is made even less likely to be aware of the presence of display 100. Surface member 30 may be larger than display 100. In other words, display 100 may be covered with surface member 30 including the front surface of which area is larger than the area of a front surface of display 100.

Information display device 10 can be provided to a structure that is disposed in wall 20. FIG. 2 is a schematic perspective view for describing installation of the information display device according to the embodiment on the structure. As illustrated in FIG. 2, information display device 10 is provided to structure 40 by fixing display 100 so that display 100 is interposed between surface member 30 and structure 40. Display 100 includes: fixing part 110 that is to be fixed to structure 40; and deformable display part 120 that is partially fixed to fixing part 110. Deformable display part 120 is a part including display panel 121 described above and displays information through surface member 30. Moreover, deformable display part 120 is deformable.

Each of FIG. 3A, FIG. 3B, and FIG. 3C is a schematic side view illustrating an example of a state in which the information display device according to the embodiment is provided to a structure. In installation of information display device 10 on structure 40, fixing part 110 is fixed to structure 40. Moreover, by providing surface member 30 to structure 40, deformable display part 120 is disposed between surface member 30 and structure 40 so that deformable display part 120 is disposed in a shape that conforms to the curved shape of surface member 30. Specifically, deformable display part 120 is deformed into a shape that conforms to surface member 30 by a pushing force exerted on deformable display part 120 by surface member 30, and deformable display part 120 is disposed in the shape that conforms to surface member 30. In contrast, fixing part 110 is more rigid than deformable display part 120 and is not deformed by the pushing force by surface member 30. Moreover, surface member 30 is disposed on the front surface 128 side of deformable display part 120 and structure 40 is disposed on the rear surface 129 side of deformable display part 120.

Surface member 30 can be provided to structure 40 and is detachably fixed to structure 40 by, for example, a bolt, a pin, a hook-and-loop fastener, or the like. The pushing force exerted on deformable display part 120 by surface member 30 is exerted by providing surface member 30 to structure 40.

Surface member 30 is a plate-like or film-like member and includes front surface 39 that is curved. The thickness of surface member 30 is uniform, for example. The curved shape of front surface 39 is not limited to a convex curved shape as illustrated in FIG. 3A. The curved shape of front surface 39 is not particularly limited and may be a concave curved shape as illustrated in FIG. 3B or a wavy curved shape as illustrated in FIG. 3C.

Surface member 30 is a member including the front surface that is the same as or similar to a member constituting the front surface of wall 20. Light from deformable display part 120 enters rear surface 38 of surface member 30 and information is displayed on front surface 39 of surface member 30. In other words, rear surface 38 of surface member 30 is a surface on a side closer to deformable display part 120 and where light from deformable display part 120 enters. Moreover, front surface 39 of surface member 30 is a surface on an opposite side to the side closer to deformable display part 120 and is seen by the user.

Rear surface 38 of surface member 30 is in tight contact with at least a region where information is displayed in front surface 128 of deformable display part 120 (a region corresponding to the display surface of display panel 121). In this case, a cushion material not illustrated in the Drawings may be disposed on rear surface 129 of deformable display part 120, and front surface 128 of deformable display part 120 may be pushed against rear surface 38 of surface member 30 by a repulsive force of the cushion material.

Moreover, deformable display part 120 is not bonded to surface member 30. In other words, there is no adhesive force by an adhesive agent or the like between deformable display part 120 and surface member 30, and deformable display part 120 and surface member 30 can be separated from each other without damaging deformable display part 120 and surface member 30. Therefore, maintenance is easy and, for example, repair, replacement, etc. of display 100 can be easily performed when display 100 is impaired.

Surface member 30 has a predetermined light transmissivity. By embedding display 100 in wall 20 (see FIG. 1) and covering display 100 with surface member 30, information display device 10 can cause information to be displayed on wall 20 without making the user aware of the presence of display 100. The light transmittance of surface member 30 is, for example, at least 8% and at most 15%. By configuring surface member 30 to have such a light transmittance, a display displayed by display 100 can be made sufficiently visible even through surface member 30 while light passing through front surface 39 toward rear surface 38 of surface member 30 is suppressed to make display 100 itself invisible from outside. In other words, when the light of deformable display part 120 is turned on, only information displayed on deformable display part 120 of display 100 becomes visible through surface member 30. Moreover, surface member 30 may be configured to include a part that is light transmissive and a part that blocks light so that only a necessary part is displayed. For example, a predetermined symbol can be displayed more clearly by providing, to surface material 30, a part that transmits light in the shape of the predetermined symbol.

For example, deformable display part 120 (specifically, display panel 121) is adjusted so that a screen luminance of deformable display part 120 through surface member 30 is at least 50 cd/m² and at most 200 cd/m² when the light of deformable display part 120 is turned on. Thus, while display 100 itself is made invisible from the front side of surface member 30, a state in which a display displayed by deformable display part 120 can be sufficiently visible through surface member 30 and the display is not too bright for the user can be realized.

It should be noted that, in order to make display 100 invisible from the front surface 39 side of surface member 30, the light transmittance of surface member 30 is set to, for example, approx. 10% (specifically, at least 8% and at most 15%) as described above. In this case, in order to cause the screen luminance of deformable display part 120 through surface member 30 to be within the above-described range, the screen luminance of deformable display part 120 (specifically, display panel 121) itself is set to, for example, at least 400 cd/m² and at most 3000 cd/m².

Surface member 30 includes, for example, a natural material such as wood, fabric, leather, or stone, a resin material imitating these, a transparent or translucent resin material whose surface is decorated by painting or printing, or the like. Thus, information display device 10 can display information without making the user visually aware of the presence of display 100.

Surface member 30 may include a hard coating (not illustrated in the Drawings) on front surface 39. Front surface 39 of surface member 30 may be frequently touched by the user. For example, when information display device 10 is used in a facility in an airplane or the like, information display device 10 may be touched by an unspecified number of people. Therefore, the hard coating preferably has a hardness of at least 2H (Japanese Industrial Standard (JIS)), for example. Thus, it is possible to prevent damage. The hard coating may be a thin layer in order to ensure the feeling of touching surface member 30. The thickness of the hard coating is, for example, at least 5 µm and at most 20 µm.

Moreover, surface member 30 may include a reflective layer (not illustrated in the Drawings) on rear surface 38. The reflective layer is made of a material such as a half-mirror and has characteristics of reflecting external light and transmitting light from display 100. By providing the reflective layer to rear surface 38 of surface member 30, display 100 can be made less visible. While an external light reflection characteristic of the reflective layer prevents the presence of display 100 itself from being seen through surface member 30, a light transmissive characteristic of the reflective layer enables the content displayed by display 100 to be presented to the user.

Structure 40 is a block that includes resin, metal, or the like. Structure 40 is, for example, held at a predetermined position inside wall 20 (see FIG. 1) by a pillar or the like. Surface member 30 and display 100 are provided to structure 40.

At least part of front surface 49 of structure 40 is in a curved shape that conforms to the curved shape of surface member 30. Moreover, in the examples illustrated in the Drawings, front surface 49 of structure 40 includes a recessed portion where fixing part 110 is provided. Fixing part 110 is fixed to structure 40. In the examples illustrated in the Drawings, fixing part 110 includes a hole into which bolt 50 is inserted, and fixing part 110 is detachably fixed to structure 40 by bolt 50. A method of fixing fixing part 110 to structure 40 is not particularly limited. Fixing part 110 is not fixed to surface member 30.

Moreover, deformable display part 120 is not bonded to structure 40. In other words, there is no adhesive force by an adhesive agent or the like between deformable display part 120 and structure 40, and deformable display part 120 and structure 40 can be separated from each other without damaging deformable display part 120 and structure 40. Although front surface 49 of structure 40 is in tight contact with rear surface 129 of deformable display part 120 in the examples illustrated in the Drawings, there may be a gap between front surface 49 and rear surface 129.

Next, the configuration of display 100 included in information display device 10 will be described in detail. FIG. 4 is a schematic top view of the display according to the present embodiment. FIG. 5 is a schematic side view of the display according to the present embodiment. FIG. 6 is a schematic cross-sectional view of the deformable display part in the display according to the present embodiment. FIG. 4 is a plan view of display 100 as viewed from the positive side in the z-axis direction (i.e., from the front surface 128 side of deformable display part 120). Moreover, FIG. 5 is a plan view of display 100 as viewed from the negative side in the y-axis direction. Furthermore, FIG. 6 is a cross-sectional view taken along line VI-VI in FIG. 4. It should be noted that, in FIG. 4, the outline of display surface 121a of display panel 121 disposed inside deformable display part 120 and the outline of fixing part 110 at a position covered with deformable display part 120 are illustrated by broken lines. Moreover, in FIG. 4, although a dot pattern is applied to a region corresponding to display surface 121a, this is for the sake of illustration and does not mean that the dot pattern is actually applied to display surface 121a. Furthermore, in FIG. 5, the outline of rigid printed circuit board 111 disposed inside fixing part 110 is illustrated by broken lines. Furthermore, in FIG. 6, the length in the z-axis direction is exaggerated for ease of viewing. In other words, in FIG. 6, the thickness of each constituent element is illustrated in an exaggerated manner.

As illustrated in FIG. 4 and FIG. 5, display 100 includes fixing part 110, deformable display part 120, and connection cable 130.

Fixing part 110 is a casing that is rigid. Fixing part 110 is more rigid than deformable display part 120. Fixing part 110 cannot be bent by hand. The shape of fixing part 110 is not particularly limited and is, for example, a rectangular parallelepiped shape. Moreover, a material of fixing part 110 is not particularly limited as long as the material is rigid enough not to be deformed easily. Fixing part 110 includes, for example, a metal or resin plate that serves as a base plate of the casing and a resin frame body that serves as a side wall extending upward from the bottom surface. The z-axis direction positive side of fixing part 110 is covered with deformable display part 120. Fixing part 110 is disposed on the rear surface 129 side of deformable display part 120 and fixed to rear surface 129. Fixing part 110 includes rigid printed circuit board 111 in its inside. Rigid printed circuit board 111 is a board on which a circuit for driving display panel 121 is provided.

Deformable display part 120 is a flexible plate-like display component that has flexibility. Deformable display part 120 can be bent by hand, for example. Information is displayed on front surface 128 of deformable display part 120. For example, deformable display part 120 can be deformed to conform to the curved shape of surface member 30 by elastic deformation. Deformable display part 120 has a plate-like shape. The thickness of deformable display part 120 is, for example, smaller than the length of fixing part 110 in the thickness direction of deformable display part 120 (in the z-axis direction). The thickness of deformable display part 120 is at least 1 mm and at most 5 mm, for example. The shape of deformable display part 120 in a plan view is not particularly limited and is, for example, a rectangle shape. It should be noted that, in the present Specification, a plan view means a view in which deformable display part 120 is viewed in a direction perpendicular to front surface 128 in a state in which deformable display part 120 is not bent.

Part of deformable display part 120 is fixed to fixing part 110. Specifically, deformable display part 120 is fixed to fixing part 110 at an x-axis direction negative side end portion of deformable display part 120 that is one end of deformable display part 120. A method of fixing part of deformable display part 120 to fixing part 110 is not particularly limited. For example, a double-sided adhesive tape, an adhesive agent, or the like (not illustrated in the Drawings) is used for fixing deformable display part 120 to fixing part 110.

Deformable display part 120 includes a portion that extends outward from a position of end surface 110a of fixing part 110 in the x-axis direction. End surface 110a of fixing part 110 is an end surface on the x-axis direction positive side.

For example, in a plan view, deformable display part 120 is divided into deformable region A1 that is not fixed to fixing part 110 and deformable and fixed region A2 that is fixed to fixing part 110. In deformable region A1, rear surface 129 of deformable display part 120 is not bound to fixing part 110. Moreover, deformable region A1 is a region that includes an x-axis direction positive side end portion of deformable display part 120 that is an other end of deformable display part 120, and since the other end is not fixed to anything, deformable region A1 of deformable display part 120 is deformed when an external force is applied. In contrast, fixed region A2 of deformable display part 120 is not deformed and still fixed to fixing part 110 when an external force is applied. The length in the x-axis direction of deformable region A1 is longer than the length in the x-axis direction of fixed region A2.

In the example illustrated in FIG. 4 and FIG. 5, deformable region A1 corresponds to a region that does not overlap fixing part 110 in deformable display part 120 in a plan view. Moreover, in the example illustrated in FIG. 4 and FIG. 5, fixed region A2 corresponds to a region that overlaps fixing part 110 in deformable display part 120 in a plan view. It should be noted that, in a plan view, not all of the region that overlaps fixing part 110 in deformable display part 120 needs to be fixed to fixing part 110. For example, part of deformable region A1 may overlap fixing part 110 in a plan view.

As illustrated in FIG. 6, deformable display part 120 includes display panel 121, cover member 122, flexible casing 123, touch panel 124, and transparent adhesive sheet 125. It should be noted that it is sufficient if deformable display part 120 includes at least display panel 121, cover member 122, and flexible casing 123.

Display panel 121 includes a light-emitting element and displays information by light emitted by the light-emitting element. Display panel 121 is, for example, an organic electroluminescent diode (OLED) panel, a matrix light-emitting diode (LED) panel, or the like.

Display panel 121 includes display surface 121a that is a surface on which information is displayed and through which light from the light-emitting element is emitted. The information displayed on display surface 121a is displayed on front surface 128 of deformable display part 120. Display surface 121a is at least part of the front surface of display panel 121. For example, in display panel 121, light-emitting elements are arranged in a matrix and display surface 121a corresponds to a range where the light-emitting elements arranged in the matrix are present. Display panel 121 is contained in flexible casing 123. Although display surface 121a slightly overlaps fixing part 110 in a plan view in the example illustrated in FIG. 4, display surface 121a does not necessarily overlap fixing part 110. The area of a portion of display surface 121a that overlaps fixing part 110 is, for example, less than or equal to 5% of the area of display surface 121a. Moreover, for example, display surface 121a does not overlap rigid printed circuit board 111 in a plan view. By causing an end portion of display surface 121a to overlap fixing part 110, a load that is applied to a connector (not illustrated in the Drawings) connecting rigid printed circuit board 111 and display panel 121 when deformable display part 120 is deformed can be reduced while keeping the deformable region of deformable display part 120. Thus, display panel 121 can be prevented from being impaired.

Display panel 121 is a flexible panel and has flexibility. In display panel 121, for example, a light-emitting element and an electrode that supplies a voltage to the light-emitting element are arranged on a flexible substrate such as a resin film substrate.

Cover member 122 is disposed on the display surface 121a side of display panel 121. Cover member 122 opposes display surface 121a of display panel 121 and completely covers display surface 121a of display panel 121. The light transmittance of cover member 122 is higher than the light transmittance of flexible casing 123. Thus, deformable display part 120 can display information more clearly. Moreover, the screen luminance of display panel 121 can be made low, and low power consumption can be achieved. It should be noted that a light transmittance here is a light transmittance in a region overlapping display surface 121a in a plan view.

Cover member 122 is, for example, an amorphous resin film made of amorphous resin. Examples of the amorphous resin include polycarbonate resin, acrylic resin, urethane resin, or the like. The amorphous resin includes: an amorphous polymer serving as a base material; and, if necessary, a resin additive such as a flame retardant. Cover member 122 may be made of polycarbonate resin among the examples of the amorphous resin. Thus, high light transmissivity and high fire resistance can be achieved. Cover member 122 has fire resistance of at least V-2 in the UL94 standard, for example. Cover member 122 may have fire resistance of V-0 in the UL94 standard.

The elastic modulus of a material constituting cover member 122 is, for example, higher than the elastic modulus of a material constituting flexible casing 123. The elastic modulus of the material constituting cover member 122 may be ten or more times higher than the elastic modulus of the material constituting flexible casing 123. The elastic modulus of the material constituting cover member 122 is, for example, at least 1000 MPa and at most 5000 MPa. The elastic modulus of the material constituting flexible casing 123 is, for example, at least 0.5 MPa and at most 100 MPa. It should be noted that an elastic modulus here is a tensile modulus at a room temperature (specifically, 25°C).

Thickness L1 of cover member 122 is less than thickness L2 of flexible casing 123 at a position overlapping display panel 121 in a plan view. Since thickness L1 of cover member 122 is thin as described above, the light transmissivity of cover member 122 can be increased. Moreover, since thickness L1 of cover member 122 is thin, cover member 122 becomes easy to bend and deformable display part 120 becomes more flexible, and thus deformable display part 120 becomes easy to conform to the curved shape of surface member 30. Moreover, since thickness L2 of flexible casing 123 is thick, the performance of flexible casing 123 for protecting display panel 121 can be enhanced. Thickness L1 of cover member 122 is, for example, at least 0.1 mm and at most 0.5 mm. Moreover, thickness L2 of flexible casing 123 is, for example, at least 0.5 mm and at most 3 mm.

Flexible casing 123 is a flexible container that contains display panel 121. Flexible casing 123 covers display panel 121 from a side opposite to the display surface 121a side of display panel 121. Flexible casing 123 includes recessed part 123a in which display panel 121 is contained. Display panel 121 is disposed above a bottom surface of recessed part 123a, and the whole of display panel 121 is placed in an internal space, which is defined by recessed part 123a, of flexible casing 123. Recessed part 123a of flexible casing 123 contains touch panel 124 and transparent adhesive sheet 125 together with display panel 121.

In the example illustrated in FIG. 6, there is a gap between display panel 121 and the bottom surface of recessed part 123a. Thus, resistance to deformation of deformable display part 120 is reduced and deformable display part 120 becomes easier to bend. Moreover, there is also a gap separating display panel 121, touch panel 124, and transparent adhesive sheet 125 from a side wall surface of recessed part 123a. It should be noted that part of these gaps may be filled with a flexible material such as an elastic body. Moreover, display panel 121, touch panel 124, and transparent adhesive sheet 125 may be contained in recessed part 123a so that at least part of these gaps is not formed.

Cover member 122 is disposed to cover recessed part 123a of flexible casing 123, and recessed part 123a of flexible casing 123 is covered by cover member 122. Display panel 121 is covered by cover member 122 and flexible casing 123 from all directions. Flexible casing 123 and cover member 122 are, for example, bonded by a double-sided adhesive tape, an adhesive agent, or the like (not illustrated in the Drawings).

Flexible casing 123 is made of an elastic body such as a rubber or an elastomer. Flexible casing 123 may be made of a silicone rubber as the rubber. Thus, high fire resistance can be achieved. For example, flexible casing 123 is integrally formed as a whole, and may be formed by connecting a plurality of members.

The approximate external appearance of deformable display part 120 is determined by flexible casing 123. In a plan view, the shape of deformable display part 120 corresponds to the shape of flexible casing 123, for example. The external shape of deformable display part 120 is defined by flexible casing 123 and cover member 122, for example.

Touch panel 124 detects an input from a user by detecting change in electrostatic capacity, pressure, light, or the like. Touch panel 124 is disposed between display panel 121 and cover member 122. A specific example of touch panel 124 is a capacitive touch panel. It should be noted that a touch sensor may be disposed instead of touch panel 124.

Transparent adhesive sheet 125 is disposed so that no gap is formed between display panel 121 and cover member 122. In the example illustrated in FIG. 6, deformable display part 120 includes: transparent adhesive sheet 125 that is disposed between display panel 121 and touch panel 124 and adheres to display panel 121 and touch panel 124; and transparent adhesive sheet 125 that is disposed between touch panel 124 and cover member 122 and adheres to touch panel 124 and cover member 122. Transparent adhesive sheet 125 is, for example, an optical clear adhesive (OCA) that is made of transparent resin such as silicone resin, acrylic resin, or urethane resin.

As illustrated in FIG. 4 and FIG. 5, connection cable 130 is connected to fixing part 110. Connection cable 130 is a cable for connecting display 100 and an external device. Electric power and a signal that are necessary for driving display 100 are supplied to display 100 via connection cable 130. It should be noted that display 100 does not necessarily include connection cable 130 and may include, instead of connection cable 130, a connector to which an external cable is connected.

### Advantageous Effects, Etc.

As described above, information display device 10 according to the present embodiment includes: front surface 39 that is curved; surface member 30 that is provided to structure 40; and display 100. Display 100 includes: fixing part 110 that is fixed to structure 40; and deformable display part 120 that displays information, is deformable, and is partially fixed to fixing part 110. Deformable display part 120 is disposed, in a shape that conforms to surface member 30, between surface member 30 and structure 40 to display information through surface member 30. Moreover, display 100 according to the present embodiment is a display included in information display device 10.

Thus, deformable display part 120 that is deformable and is a portion where information is displayed is disposed in a shape that conforms to surface member 30 while display 100 is fixed to structure 40 by fixing part 110. Therefore, information display device 10 that causes information to be displayed through surface member 30 can conforms to the curved shape of surface member 30.

Moreover, in information display device 10 according to the present embodiment, deformable display part 120 may be fixed to fixing part 110 at one end of deformable display part 120.

Thus, a movable range of deformable display part 120 can be easily increased.

Moreover, in information display device 10 according to the present embodiment, deformable display part 120 is not necessarily bonded to surface member 30 and structure 40.

Thus, deformable display part 120 can be separated from surface member 30 and structure 40 without damaging deformable display part 120, surface member 30, and structure 40. Therefore, display 100 can be easily detached for maintenance.

Moreover, in information display device 10 according to the present embodiment, deformable display part 120 may be disposed in a shape that conforms to surface member 30 by a pushing force exerted on deformable display part 120 by surface member 30.

Thus, by pushing deformable display part 120 by surface member 30, a gap is prevented from being formed between surface member 30 and deformable display part 120, and display of information is prevented from being blurred.

Moreover, in information display device 10 according to the present embodiment, when the light of deformable display part 120 is turned on, only information displayed on deformable display part 120 of display 100 may become visible through surface member 30.

Thus, information can be displayed without making a user aware of the presence of display 100.

Moreover, in information display device 10 according to the present embodiment, deformable display part 120 may include display panel 121 that includes a light-emitting element and displays information by light emitted from the light-emitting element, and surface member 30 may be larger than display panel 121.

Thus, since an edge of surface member 30 is not disposed at a position overlapping display panel 121, a user is made even less likely to be aware of the presence of display 100.

Moreover, in information display device 10 according to the embodiment, deformable display part 120 may include: display panel 121 that includes a light-emitting element and displays information by light emitted from the light-emitting element; cover member 122 that covers display surface 121a of display panel 121; and flexible casing 123 that is flexible, covers display panel 121 from a side opposite to the display surface 121a side of display panel 121, and includes recessed part 123a that contains display panel 121.

Thus, deformable display part 120 that is deformable can be achieved without exposing display panel 121.

Moreover, in information display device 10 according to the present embodiment, the light transmittance of cover member 122 may be higher than the light transmittance of flexible casing 123.

Thus, deformable display part 120 can display information more clearly. Moreover, the screen luminance of display panel 121 can be made low, and low power consumption can be achieved.

Moreover, in information display device 10 according to the present embodiment, cover member 122 may be made of polycarbonate resin and flexible casing 123 may be made of silicone rubber.

Thus, high light transmissivity and high fire resistance can be achieved in deformable display part 120.

Moreover, in information display device 10 according to the present embodiment, thickness L1 of cover member 122 may be less than thickness L2 of flexible casing 123 at a position overlapping display panel 121 in a plan view.

Thus, since thickness L1 of cover member 122 is thin, the light transmissivity of cover member 122 can be increased, cover member 122 becomes easy to bend, and deformable display part 120 becomes easy to conform to the curved shape of surface member 30. Moreover, since thickness L2 of flexible casing 123 is thick, the performance of flexible casing 123 for protecting display panel 121 can be enhanced.

Moreover, information display device 10 according to the present embodiment may be provided to a mobile body.

Thus, information display device 10 is provided to a mobile body that is likely to include a curved wall or the like.

### [Other examples of a method of arranging a deformable display part]

Although deformable display part 120 is disposed in a shape that conforms to surface member 30 by a pushing force exerted on deformable display part 120 by surface member 30 in the above-described example, the present disclosure is not limited to this example. Hereinafter, other methods of arranging deformable display part 120 in a shape that conforms to surface member 30 will be described.

First, a first example of a method of arranging deformable display part 120 in a shape that conforms to surface member 30 will be described. FIG. 7 is a schematic perspective view for describing a surface member and a structure that have an other configuration according to the present embodiment. FIG. 8 is a schematic side view illustrating a state in which a display according to the present embodiment is provided to the structure that has the other configuration.

In the example illustrated in FIG. 7 and FIG. 8, surface member 30A and structure 40A are integrally formed and surface member 30A is provided to structure 40A in advance. Gap 60 in a shape that conforms to the curved shape of surface member 30A is formed between surface member 30A and structure 40A. Gap 60 may be a through gap or a gap having a closed bottom.

In the example illustrated in FIG. 7 and FIG. 8, deformable display part 120 is disposed in a shape that conforms to surface member 30A by inserting display 100 into gap 60 while deforming deformable display part 120 into the shape of gap 60. Deformable display part 120 is, for example, in tight contact with surface member 30A by an elastic force of deformable display part 120. In gap 60, fixing part 110 is fixed to structure 40A by bolt 50 or the like.

Next, a second example of the method of arranging deformable display part 120 in a shape that conforms to surface member 30 will be described. FIG. 9 is a schematic cross-sectional view illustrating a state in which the deformable display part according to the present embodiment is disposed along a guide provided to the structure. FIG. 10 is a schematic cross-sectional view illustrating a state in which the deformable display part according to the present embodiment is disposed along a guide provided to the surface member. FIG. 9 and FIG. 10 illustrate a cross section of each of deformable display parts 120B and 120 at a position corresponding to FIG. 6. Moreover, in FIG. 9 and FIG. 10, an illustration of a detailed internal cross-sectional structure of each of deformable display parts 120B and 120 is omitted.

In the example illustrated in FIG. 9, guide 41 is provided to structure 40B. A portion of the front surface of structure 40B is protruded, and guide 41 is a groove that is provided at the protruded portion of structure 40B and extends corresponding to the curved shape of surface member 30. Guide 41 is provided to a position at which guide 41 is spaced from surface member 30 when surface member 30 is provided to structure 40B. Guide 41 may include a rail. Two guides 41 are arranged opposite to each other so that deformable display part 120B can be interposed between guides 41.

Moreover, deformable display part 120B illustrated in FIG. 9 has the same configuration as that of deformable display part 120 except that deformable display part 120B includes guided part 127 in a shape that conforms to guide 41. Guided part 127 is a protruded portion on a side surface of deformable display part 120B. Since the thickness of deformable display part 120B on a surface member 30 side is reduced at guided part 127, the thickness of guided part 127 is thinner than the thickness of the central portion of deformable display part 120B. Guided part 127 is, for example, part of flexible casing 123 (see FIG. 6). It should be noted that guided part 127 may be formed as a separate member from flexible casing 123 and connected to flexible casing 123.

In the example illustrated in FIG. 9, deformable display part 120B is disposed in a shape that conforms to surface member 30 by disposing guided part 127 along guide 41. Since the position and shape of deformable display part 120B is determined by guide 41, deformable display part 120B can be deformed and disposed so that deformable display part 120B becomes in tight contact with surface member 30, depending on the design of guide 41.

Moreover, in the example illustrated in FIG. 10, guide 33 is provided to surface member 30B. Surface member 30B includes: main part 31 that is in a plate-like or film-like shape and has the same configuration as that of surface member 30 described above; and guide part 32 for forming guide 33 on the rear surface of main part 31. Guide part 32 extends corresponding to the curved shape of surface member 30B. Guide 33 that is in a groove-like shape is provided to surface member 30B by providing, to the rear surface of main part 31, guide part 32 of which cross-section orthogonal to the extending direction of guide part 32 is in an L-shape. Two guides 33 are arranged opposite to each other so that deformable display part 120 can be interposed between guides 33.

In the example illustrated in FIG. 10, deformable display part 120 is disposed in a shape that conforms to surface member 30B (specifically, main part 31) by disposing an end portion of deformable display part 120 along guide 33. Since the position and shape of deformable display part 120 is determined by guide 33, deformable display part 120 can be deformed and disposed so that deformable display part 120 becomes in tight contact with main part 31 of surface member 30B, depending on the design of guide 33.

Next, a third example of the method of arranging deformable display part 120 in a shape that conforms to surface member 30 will be described. FIG. 11 is a schematic top view illustrating a display that has an other configuration according to the present embodiment.

Display 100C illustrated in FIG. 11 has a configuration in which fixing part 140 is added to display 100 described above. In display 100C, fixing part 140 is connected to an x-axis direction positive side end portion of deformable display part 120 that is the other end of deformable display part 120 in the x-axis direction. Fixing part 140 is a rigid plate or block that is made of resin, metal, or the like. Fixing part 140 is more rigid than deformable display part 120. Fixing part 140 cannot be bent by hand. For example, fixing part 140 includes a hole, and fixing part 140 is fixed to structure 40 by a bolt or the like that is inserted into the hole. In display 100C, deformable display part 120 is disposed in a shape that conforms to surface member 30 by fixing, to structure 40, fixing parts 110 and 140 that are arranged at both ends of deformable display part 120.

### Variations

Next, variations of the embodiment will be described. Hereinafter, the description will be focused on the difference from the above-described embodiment, and the description of things in common with the above-described embodiment will be omitted or simplified.

FIG. 12 is a schematic bottom view of a display according to the present variation. FIG. 13 is a schematic side view of the display according to the present variation. FIG. 12 is a plan view of display 101 as viewed from the negative side in the z-axis direction (i.e., from the rear surface 129 side of deformable display part 120). Moreover, FIG. 13 is a plan view of display 101 as viewed from the negative side in the y-axis direction. It should be noted that, in FIG. 12, the outline of reinforcement part 150 at a position covered with fixing part 110 is illustrated by a broken line. Moreover, in FIG. 12, the density of dots in the dot pattern applied to a portion of reinforcement part 150 on the x-axis direction positive side with respect to end surface 110a corresponds to the rigidity of reinforcement part 150, and a higher density of dots indicates a higher rigidity. Moreover, although connection cable 130 illustrated in FIG. 4 and FIG. 5 is not illustrated in FIG. 12 and FIG. 13, display 101 may include connection cable 130.

An information display device according to the present variation has a configuration in which display 100 of information display device 10 described above has been replaced with display 101. As illustrated in FIG. 12 and FIG. 13, display 101 according to the present variation is different from display 100 described above in that display 101 further includes reinforcement part 150. Display 101 has a configuration in which reinforcement part 150 is added to the configuration of display 100.

Reinforcement part 150 is a plate-like reinforcement member. Reinforcement part 150 is made of, for example, wood, resin, metal, or the like. In the example illustrated in FIG. 12, the shape of reinforcement part 150 in a plan view is a rectangle shape. Reinforcement part 150 is disposed on rear surface 129 of deformable display part 120. Reinforcement part 150 overlaps deformable display part 120 in a plan view. The rigidity of reinforcement part 150 is lower than that of fixing part 110, and reinforcement part 150 can be deformed together with deformable display part 120. It should be noted that the position of reinforcement part 150 is not particularly limited as long as reinforcement part 150 can be deformed together with deformable display part 120 and display of information by deformable display part 120 is not disturbed. For example, reinforcement part 150 may be disposed so that reinforcement part 150 is embedded in rear surface 129 of deformable display part 120. Reinforcement part 150 may be embedded in flexible casing 123 of deformable display part 120 (see FIG. 6).

Reinforcement part 150 includes a portion that extends from a position of end surface 110a of fixing part 110 outward from fixing part 110 in the x-axis direction. In the example illustrated in FIG. 12 and FIG. 13, an x-axis direction positive side end of reinforcement part 150 that is a distal end of reinforcement part 150 with respect to fixing part 110 is closer to fixing part 110 than an x-axis direction positive side end of deformable display part 120 in the x-axis direction. It should be noted that the x-axis direction positive side end of reinforcement part 150 may be at the same position as the x-axis direction positive side end of deformable display part 120 or be farther from fixing part 110 than the x-axis direction positive side end of deformable display part 120 is in the x-axis direction.

Moreover, in the example illustrated in FIG. 12 and FIG. 13, part of reinforcement part 150 overlaps fixing part 110 in a plan view and is interposed between fixing part 110 and deformable display part 120. Reinforcement part 150 extends outward from the position of end surface 110a of fixing part 110 in the x-axis direction. At least part of reinforcement part 150 is fixed to at least one of fixing part 110 or deformable display part 120. Reinforcement part 150 may be integrated with fixing part 110 or deformable display part 120.

The rigidity of reinforcement part 150 decreases as the distance from the position of end surface 110a of fixing part 110 increases (i.e., as the distance from the distal end of reinforcement part 150 with respect to fixing part 110 decreases) in the x-axis direction. Here, rigidity is rigidity against bending in the thickness direction of deformable display part 120 (in the z-axis direction). In other words, reinforcement part 150 becomes easier to bend as the distance from the position of end surface 110a of fixing part 110 increases in the x-axis direction.

In the example illustrated in FIG. 12 and FIG. 13, reinforcement part 150 is a member that has a uniform thickness (the length in the z-axis direction) and a uniform width (the length in the y-axis direction), and as the distance from the position of end surface 110a of fixing part 110 increases, the bending strength of the material constituting reinforcement part 150 itself decreases and thus the rigidity of reinforcement part 150 decreases. For example, a plurality of slits that extend in the y-axis direction are formed in reinforcement part 150, and the density of the plurality of slits formed in reinforcement part 150 per unit area increases as the distance from the position of end surface 110a of fixing part 110 increases. Thus, as the distance from the position of end surface 110a of fixing part 110 increases, the number of slits increases and thus the bending strength of the material constituting reinforcement part 150 decreases. It should be noted that a method of reducing the strength of the material of reinforcement part 150 as the distance from the position of end surface 110a of fixing part 110 increases is not limited to forming slits and not particularly limited. For example, the density or elastic modulus of the material of reinforcement part 150 may decrease as the distance from the position of end surface 110a of fixing part 110 increases.

As described above, display 101 according to the present variation includes: fixing part 110 that is a rigid casing; deformable display part 120 that displays information, is deformable, is partially fixed to fixing part 110, and extends outward from the position of end surface 110a of fixing part 110 in the x-axis direction; and reinforcement part 150 that overlaps deformable display part 120 in a plan view and can be deformed together with deformable display part 120. Reinforcement part 150 includes a portion extending outward from the position of end surface 110a of fixing part 110 in the x-axis direction, and the rigidity of reinforcement part 150 decreases as the distance from the position of end surface 110a of fixing part 110 increases.

The vicinity of a position overlapping end surface 110a of fixing part 110 in a plan view is a portion that is easy to bend locally when deformable display part 120 is deformed. In display 101, since reinforcement part 150 that includes the portion extending outward from the position of end surface 110a of fixing part 110 is disposed, reinforcement part 150 can make deformable display part 120 difficult to bend locally. Moreover, if the rigidity of the distal end of reinforcement part 150 with respect to fixing part 110 is high, that is, if reinforcement part 150 is difficult to bend, deformable display part 120 becomes easy to bend locally at the distal end of reinforcement part 150 with respect to fixing part 110. However, in display 101, since the rigidity of reinforcement part 150 decreases as the distance from the position of end surface 110a of fixing part 110 increases, deformable display part 120 becomes difficult to bend locally even at the distal end of reinforcement part 150 with respect to fixing part 110. For example, when power is applied to an x-axis direction positive side end portion of deformable display part 120 as indicated by a white arrow in FIG. 13, deformable display part 120 is prevented from bending locally and is easily curved as a whole. Therefore, deformable display part 120 can be prevented from being damaged.

It should be noted that the form of reinforcement part 150 is not limited to the example illustrated in FIG. 12 and FIG. 13. FIG. 14 is a schematic bottom view of a display that includes a reinforcement part according to a first example of the present variation. FIG. 15 is a schematic bottom view of a display that includes a reinforcement part according to a second example of the present variation. FIG. 16 is a schematic bottom view of a display that includes a reinforcement part according to a third example of the present variation. FIG. 14, FIG. 15, and FIG. 16 are plan views of displays 101A, 101B, and 101C viewed from the negative side in the z-axis direction (i.e., from the rear surface 129 side of deformable display part 120). It should be noted that in FIG. 14, FIG. 15, and FIG. 16, the outline of each of reinforcement parts 150A, 150B, and 150C at a position covered with fixing part 110 is indicated by a broken line.

In FIG. 14, FIG. 15, and FIG. 16, displays 101A, 101B, and 101C in each of which reinforcement part 150 of display 101 has been replaced with a corresponding one of reinforcement parts 150A, 150B, and 150C are illustrated.

As the distance from the position of end surface 110a of fixing part 110 increases in the x-axis direction, the width (the length in the y-axis direction) of each of reinforcement parts 150A, 150B, and 150C illustrated in FIG. 14, FIG. 15, and FIG. 16 decreases and thus the rigidity of each of reinforcement parts 150A, 150B, and 150C decreases. In the examples illustrated in FIG. 14, FIG. 15, and FIG. 16, the width of each of reinforcement parts 150A, 150B, and 150C is the same as the width of deformable display part 120 at the position of end surface 110a of fixing part 110 in the x-axis direction.

As the distance from the position of end surface 110a of fixing part 110 increases, the width of each of reinforcement parts 150A and 150B illustrated in FIG. 14 and FIG. 15 decreases in a straight manner to form a triangle shape in a plan view. Moreover, as the distance from the position of end surface 110a of fixing part 110 increases, the width of reinforcement part 150C illustrated in FIG. 16 decreases in a curved manner to form a semicircle or semi-ellipsoid shape that protrudes from fixing part 110 in a plan view.

Furthermore, reinforcement part 150B illustrated in FIG. 15 includes a portion that extends outward from the position of end surface 110a of fixing part 110 in the x-axis direction and that is divided into two. The width of each of the two divided portions of reinforcement part 150B decreases as the distance from the position of end surface 110a of fixing part 110 increases. It should be noted that the above-described portion of reinforcement part 150B may be divided into three or more. Moreover, the width of the above-described portion of reinforcement part 150B may decrease in a curved manner similar to reinforcement part 150C.

In the example illustrated in FIG. 15, in a plan view, an x-axis direction positive side end of each of the two divided portions of reinforcement part 150B is positioned at a different one of outer edges of deformable display part 120 in the y-axis direction. It should be noted that, in a plan view, the x-axis direction positive side end of each of the two divided portions may be positioned inside the outer edges of deformable display part 120 in the y-axis direction.

FIG. 17 is a schematic side view of a display that includes a reinforcement part according to a fourth example of the present variation. FIG. 17 is a plan view of display 101 as viewed from the negative side in the y-axis direction. FIG. 17 illustrates display 101D that has a configuration in which reinforcement part 150 of display 101 has been replaced with reinforcement part 150D.

As the distance from the position of end surface 110a of fixing part 110 increases in the x-axis direction, the thickness (the length in the z-axis direction) of reinforcement part 150D illustrated in FIG. 17 decreases and thus the rigidity of reinforcement part 150D decreases. In the example illustrated in FIG. 17, reinforcement part 150D and deformable display part 120 are integrally formed. Reinforcement part 150D is, for example, part of flexible casing 123 (see FIG. 6). Reinforcement part 150D is formed by thickening part of flexible casing 123. It should be noted that reinforcement part 150D may be formed separately from deformable display part 120 and then joined to deformable display part 120.

### Other Embodiments, etc.

Although an information display device and a display according to one or more aspects of the present disclosure have been described above based on the embodiment, the present disclosure is not limited to the embodiment. Forms obtained by various modifications to the embodiment that can be conceived by a person skilled in the art as well as forms implemented by combining constituent elements in the embodiment may be included in the scope of the one or more aspects of the present disclosure as long as they do not depart from the essence of the present disclosure.

For example, although the information display device is provided to a mobile body in the above-described embodiment, the present disclosure is not limited to this example. For example, the information display device may be provided to a building such as an office, a factory, accommodation, a commercial facility.

Moreover, although only a fixing part of a display is fixed to a structure in the above-described embodiment, the present disclosure is not limited to this example. A deformable display part of a display may be fixed to a structure. Moreover, at least one of a fixing part or deformable display part of a display may be fixed to a surface member by an adhesive agent or the like.

Furthermore, although only information displayed on a deformable display part of a display becomes visible through a surface member when the light of the deformable display part is turned on in the above-described embodiment, the present disclosure is not limited to this example. A portion other than the information displayed on a deformable display part of a display may become visible through a surface member when the light of the deformable display part is turned on.

Moreover, although at least part of a front surface of a structure is in a curved shape that conforms to the curved shape of a surface member in the above-described embodiment, the present disclosure is not limited to this example. A front surface of a structure may be flat.

Moreover, although a display is used in an information display device that causes information to be displayed through a surface member in the above-described embodiment, the present disclosure is not limited to this example. A display may be used alone as a flexible display.

### Supplementary Note

Hereinafter, examples of the technique that has been described based on the embodiment are shown. It should be noted that the present disclosure is not limited to the techniques described below.

### [Technique 1]

An information display device is to be provided to a structure and includes: a surface member that is provided to the structure and includes a front surface that is curved; and a display. The display includes: a fixing part that is fixed to the structure; and a deformable display part that displays information, is deformable, and is partially fixed to the fixing part. The deformable display part is disposed between the surface member and the structure to display the information through the surface member. The deformable display part is disposed in a shape that conforms to the surface member.

### [Technique 2]

In the information display device according to Technique 1, the deformable display part is fixed to the fixing part at one end of the deformable display part.

### [Technique 3]

In the information display device according to Technique 1 or Technique 2, the deformable display part is not bonded to neither the surface member nor the structure.

### [Technique 4]

In the information display device according to any one of Technique 1 to Technique 3, the deformable display part is disposed in the shape that conforms to the surface member by a pushing force exerted on the deformable display part by the surface member.

### [Technique 5]

In the information display device according to any one of Technique 1 to Technique 3, the deformable display part is disposed in the shape that conforms to the surface member by being disposed along a guide that is provided to the surface member or the structure.

### [Technique 6]

In the information display device according to Technique 5, the deformable display part includes a guided part that is in a shape corresponding to the guide.

### [Technique 7]

In the information display device according to any one of Technique 1 to Technique 6, when a light of the deformable display part is turned on, only the information displayed by the deformable display part of the display becomes visible through the surface member.

### [Technique 8]

In the information display device according to any one of Technique 1 to Technique 7, the deformable display part includes a display panel that includes a light-emitting element and that displays the information by light emitted from the light-emitting element, and the surface member is bigger than the display panel.

### [Technique 9]

In the information display device according to any one of Technique 1 to Technique 8, the deformable display part includes: a display panel that includes a light-emitting element and displays the information by light emitted from the light-emitting element; a cover member that covers a display surface of the display panel; and a flexible casing that is flexible, covers the display panel from a side opposite to the display surface of the display panel, and includes a recessed part that contains the display panel.

### [Technique 10]

In the information display device according to Technique 9, a light transmittance of the cover member is higher than a light transmittance of the flexible casing.

### [Technique 11]

In the information display device according to Technique 9 or Technique 10, the cover member is made of polycarbonate resin, and the flexible casing is made of silicone rubber.

### [Technique 12]

In the information display device according to any one of Technique 9 to Technique 11, a thickness of the cover member is less than a thickness of the flexible casing at a position overlapping the display panel in a plan view.

### [Technique 13]

In the information display device according to any one of Technique 1 to Technique 12, the information display device is provided to a mobile body.

### [Technique 14]

A display is the display included in the information display device according to any one of Technique 1 to Technique 13.

### Industrial Applicability

An information display device and a display according to the present disclosure is, for example, applicable to an information display device and a display that are provided to a mobile body such as an airplane.

### Reference Signs List

10 information display device
20 wall
30, 30A, 30B surface member
31 main part
32 guide part
33, 41 guide
38, 129 rear surface
39, 49, 128 front surface
40, 40A, 40B structure
50 bolt
100, 100C, 101, 101A, 101B, 101C, 101D display
110, 140 fixing part
110a end surface
111 rigid printed circuit board
120, 120B deformable display part
121 display panel
121a display surface
122 cover member
123 flexible casing
123a recessed part
124 touch panel
125 transparent adhesive sheet
127 guided part
130 connection cable
150, 150A, 150B, 150C, 150D reinforcement part
A1 deformable region
A2 fixed region

## Claims

1. An information display device to be provided to a structure, the information display device comprising:
a surface member that is provided to the structure and includes a front surface that is curved; and
a display, wherein
the display includes:
a fixing part that is fixed to the structure; and
a deformable display part that displays information, is deformable, and is partially fixed to the fixing part, and
the deformable display part is disposed between the surface member and the structure to display the information through the surface member, the deformable display part being disposed in a shape that conforms to the surface member.

2. The information display device according to claim 1, wherein
the deformable display part is fixed to the fixing part at one end of the deformable display part.

3. The information display device according to claim 1 or 2, wherein
the deformable display part is not bonded to neither the surface member nor the structure.

4. The information display device according to any one of claims 1 to 3, wherein
the deformable display part is disposed in the shape that conforms to the surface member by a pushing force exerted on the deformable display part by the surface member.

5. The information display device according to any one of claims 1 to 3, wherein
the deformable display part is disposed in the shape that conforms to the surface member by being disposed along a guide that is provided to the surface member or the structure.

6. The information display device according to claim 5, wherein
the deformable display part includes a guided part that is in a shape corresponding to the guide.

7. The information display device according to claim 1, wherein
when a light of the deformable display part is turned on, only the information displayed by the deformable display part of the display becomes visible through the surface member.

8. The information display device according to any one of claims 1 to 6, wherein
the deformable display part includes a display panel that includes a light-emitting element and that displays the information by light emitted from the light-emitting element, and
the surface member is bigger than the display panel.

9. The information display device according to any one of claims 1 to 7, wherein
the deformable display part includes:
a display panel that includes a light-emitting element and displays the information by light emitted from the light-emitting element;
a cover member that covers a display surface of the display panel; and
a flexible casing that is flexible, covers the display panel from a side opposite to the display surface of the display panel, and includes a recessed part that contains the display panel.

10. The information display device according to claim 9, wherein
a light transmittance of the cover member is higher than a light transmittance of the flexible casing.

11. The information display device according to claim 9 or 10, wherein
the cover member is made of polycarbonate resin, and
the flexible casing is made of silicone rubber.

12. The information display device according to any one of claims 9 to 11, wherein
a thickness of the cover member is less than a thickness of the flexible casing at a position overlapping the display panel in a plan view.

13. The information display device according to any one of claims 1 to 12, wherein
the information display device is provided to a mobile body.

14. A display that is the display included in the information display device according to any one of claims 1 to 13.
